# FASCICULE DE BREVET EUROPEEN

(11) **EP 0 578 520 B1**
(45) Date de publication et mention de la délivrance du brevet: **28.01.1998**
(21) Numéro de dépôt: 93401505.8
(22) Date de dépôt: 11.06.1993
(51) Int. Cl.: H05K 7/14

(54) **Structure modulaire porte-carte de circuit imprimé, apte à venir s'engager, à la façon d'un tiroir, dans une baie d'une installation électronique**
Modularer Einschub-Leiterplattenträger für Baugruppenträger
Modular PCB-holder for drawer-like inserting in an electronic rack

(30) Priorité: 08.07.1992 FR 9208436
(43) Date de publication de la demande: 12.01.1994
(73) Titulaire: SEXTANT AVIONIQUE, F-92366 Meudon la Foret Cédex (FR)
(72) Inventeur: Nemoz, Gérard, F-94700 Maisons Alfort (FR)
(74) Mandataire: de Saint-Palais, Arnaud Marie

(56) Documents cités:
- WO-A-88/08662
- FR-A- 2 534 109
- FR-A- 2 582 898
- JP-A-62 117 399
- US-A- 4 931 909
- IBM TECHNICAL DISCLOSURE BULLETIN. vol. 33, no. 6A, Novembre 1990, NEW YORK US pages 441 - 443 'METHOD FOR INCREASING VOLUME OF LOGIC BOOKS'

## Description

La présente invention concerne une structure modulaire porte-carte de circuit imprimé, apte à venir s'engager, à la façon d'un tiroir, dans une baie d'une installation électronique et à se connecter, grâce à des moyens de connexion intégrés sur des éléments d'interconnexion prévus dans le fond de la baie (interconnexions fond de panier).

Elle s'applique notamment, mais non exclusivement, aux installations électroniques situées à bord d'un aérodyne.

D'une manière générale, on sait que les structures de ce genre utilisées à l'heure actuelle, se présentent sous la forme de boîtiers, logeant les cartes de circuit imprimé et dont l'ensemble de la face arrière supporte des éléments de connexion mécanique et électrique appropriés à la fois à ceux de la baie et à ceux des cartes de circuit imprimé.

Il s'avère que cette solution présente un certain nombre d'inconvénients.

Elle implique tout d'abord plusieurs niveaux de connexion entre la carte de circuit imprimé et les connecteurs fixés sur la face arrière de la baie : Ces connecteurs comprennent chacun un corps en général parallélépipédique muni de moyens de fixation et logeant une pluralité d'éléments de connexion montés dans un ou plusieurs blocs isolants ; chacun de ces éléments comprend une partie externe conformée de manière à venir coopérer avec des éléments de connexion correspondants prévus dans le fond de la baie, et une partie interne reliée au circuit électronique de la carte, habituellement par l'intermédiaire d'une barrette de connecteurs.

Par ailleurs, cette solution est relativement lourde, coûteuse à réaliser et est thermiquement peu satisfaisante : Elle se prête mal aux échanges thermiques nécessaires notamment pour évacuer les calories dégagées par les composants électroniques portés par la carte de circuit imprimé.

C'est enfin une structure relativement figée et peu associative qui n'offre donc que des possibilités limitées notamment en matière d'implantation et de dimension des composants qu'elle est censée recevoir.

Dans les structures décrites dans les brevets US-A-4 931 909 et JP-A-62-117 399, on n'a pas prévu d'intégrer les blocs de connexion de la carte de circuit imprimé.

L'invention a donc plus particulièrement pour but de supprimer ces inconvénients.

Elle propose une structure modulaire relativement simple, tant en ce qui concerne sa conception que sa mise en oeuvre et qui permet notamment :
- la réalisation de boîtiers ou tiroirs d'épaisseur variable, pouvant contenir une ou plusieurs cartes de circuit imprimé interconnectables directement ;
- le maintien efficace et le raidissement des cartes de circuit imprimé ;
- l'intégration des blocs d'éléments de connexion à la structure sans avoir à utiliser les autres éléments des connecteurs classiques (en particulier, leur partie mécanique) ;
- la réduction, à un seul niveau, des connexions entre les cartes du circuit imprimé et le connecteur de sortie de la structure modulaire ;
- l'établissement de ponts de conduction thermique directe entre les éléments de circuit imprimé sièges d'émission calorifiques et des parois externes thermiquement conductrices jouant le rôle de dissipateurs thermiques ;
- l'intégration de moyens de positionnement, de détrompage et de verrouillage des boîtiers.

Pour parvenir à ces résultats, la structure selon l'invention comprend au moins un cadre réalisé de préférence en une matière moulée, qui délimite au moins un volume plat de forme parallélépipédique et dont le bord du contour intérieur, au moins en partie mouluré, présente des éléments de feuillure sur lesquels peut être fixée une carte de circuit imprimé contenue dans ledit volume, ledit cadre comprenant un montant antérieur conformé de manière à présenter au moins une échancrure dans laquelle est engagé et fixé un ensemble d'éléments de connexion dont les parties internes sont directement reliées, par l'intermédiaire de liaisons conductrices, à des plages conductrices du circuit imprimé, ce cadre comprenant, par ailleurs, deux flancs latéraux munis de moyens de fixation, sur chacun desquels peuvent venir se fixer soit une plaque de fermeture, de préférence en un matériau thermiquement bon conducteur, soit un deuxième cadre identique au premier de manière à ce que les échancrures des montants antérieurs respectifs des deux cadres soient en coïncidence.

Avantageusement, le susdit montant antérieur du cadre pourra comprendre sur sa face extérieure, des moyens de détrompage aptes à coopérer avec des moyens correspondants prévus dans le fond de la baie, pour interdire toute possibilité d'erreur de connexion.

Par ailleurs, le montant postérieur du cadre pourra être conformé de manière à recevoir un mécanisme de verrouillage permettant de verrouiller la structure en position engagée et connectée à la baie.

Un mode d'exécution de l'invention sera décrit ci-après, à titre d'exemple non limitatif, avec référence aux dessins annexés dans lesquels :
La figure 1 est une vue en perspective montrant une baie à l'intérieur de laquelle sont disposées des structures modulaires porte-carte selon l'invention ;
La figure 2 est une vue de côté d'un cadre utilisé dans chacune des structures modulaires ;
La figure 3 est une vue en élévation de la face antérieure du cadre, muni des blocs de connexion ;
La figure 4 est une vue en perspective d'une structure modulaire à l'état assemblé qui comporte au moins deux des cadres illustrés figures 1 à 3 ;
Les figures 5, 6 et 7 sont des vues en perspective éclatée illustrant trois variantes d'exécution d'une structure modulaire selon l'invention.

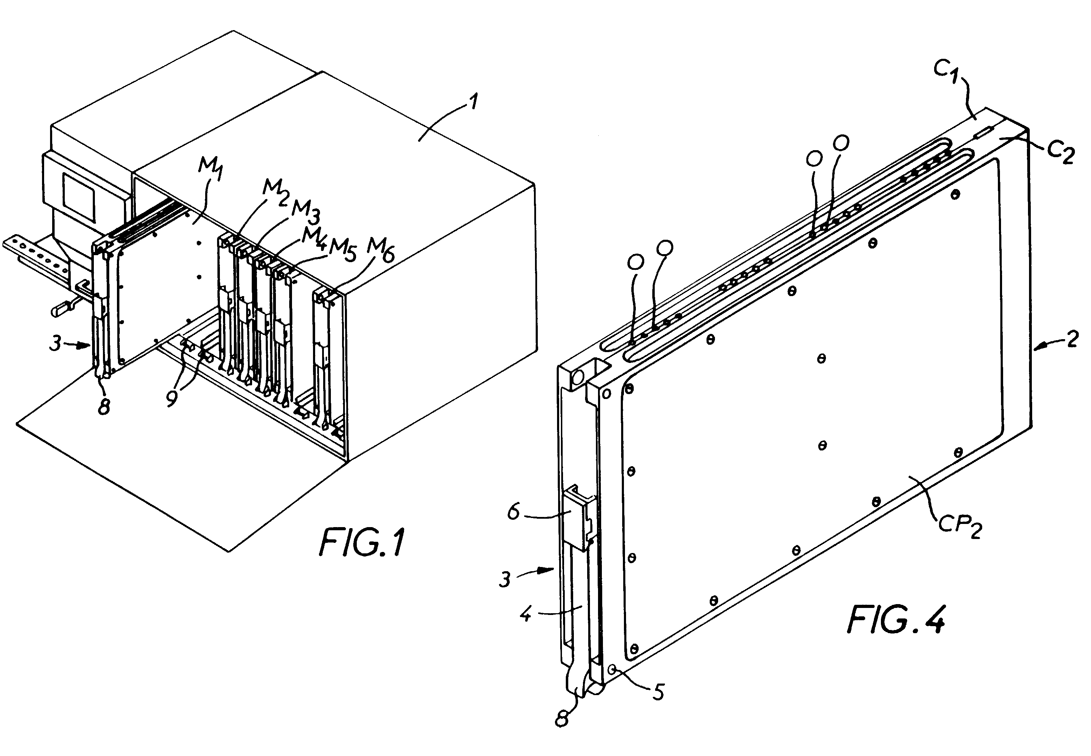

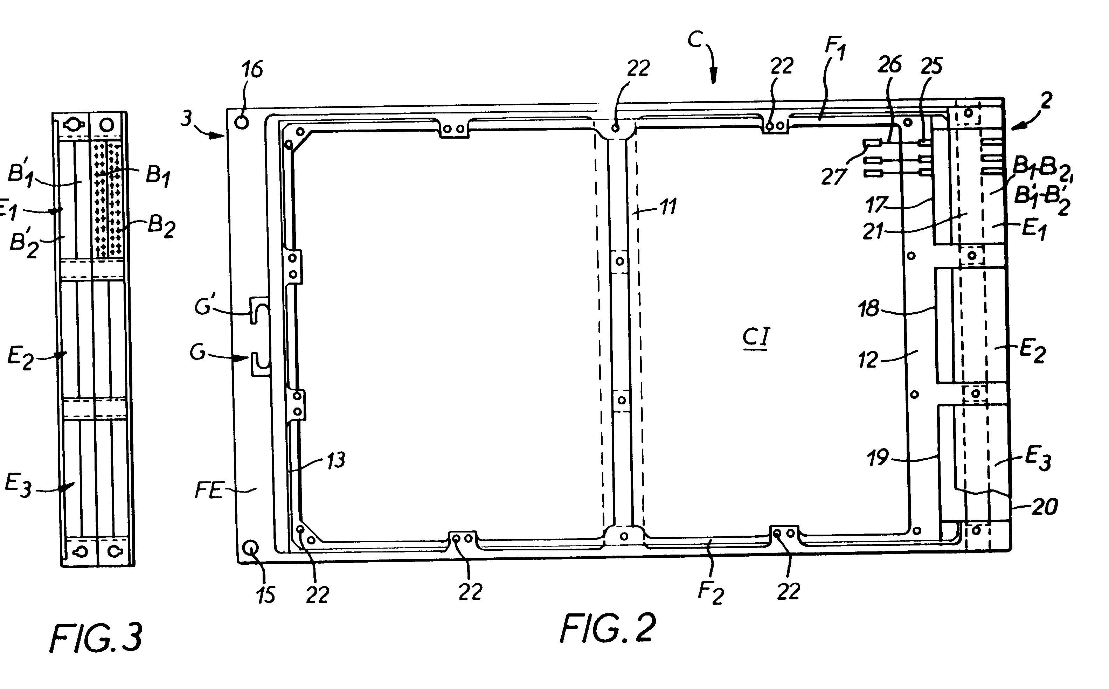

Telles que représentées sur la figure 1, les structures modulaires M₁ à M₆, dont l'une (M₁) se trouve partiellement engagée dans la baie d'un appareil électronique, présente une forme plate, sensiblement parallélépipédique dont la face antérieure (visible sur les figures 2 et 3) est munie de trois groupes de connexion E₁, E₂, E₃, destinés à coopérer avec des connecteurs correspondants placés dans le fond de la baie 1 (connecteurs fond de panier). L'ensemble des trois groupes de connexion E₁, E₂, E₃ forme l'équivalent d'un connecteur usuel.

La face postérieure 3 de chacune de ces structures modulaires est munie d'un (ou de deux) dispositif(s) de verrouillage faisant intervenir un levier basculant 4, monté pivotant autour d'un axe 5 situé à proximité de la face inférieure et dont la partie supérieure porte une pièce de verrouillage oscillante 6 dont une partie en forme de pêne vient s'engager dans une conformation servant de gâche G, prévue sur la face postérieure 3.

L'extrémité inférieure du levier 4, en forme de fourche 8, est elle-même destinée à venir s'engager dans un étrier 9 monté coulissant sur la face inférieure de la baie 1 et rappelé par un ressort (non représenté) vers l'intérieur de la baie, de manière à amener la structure modulaire en pression permanente sur le fond de la baie.

Le fonctionnement de ce mécanisme de verrouillage est alors le suivant :

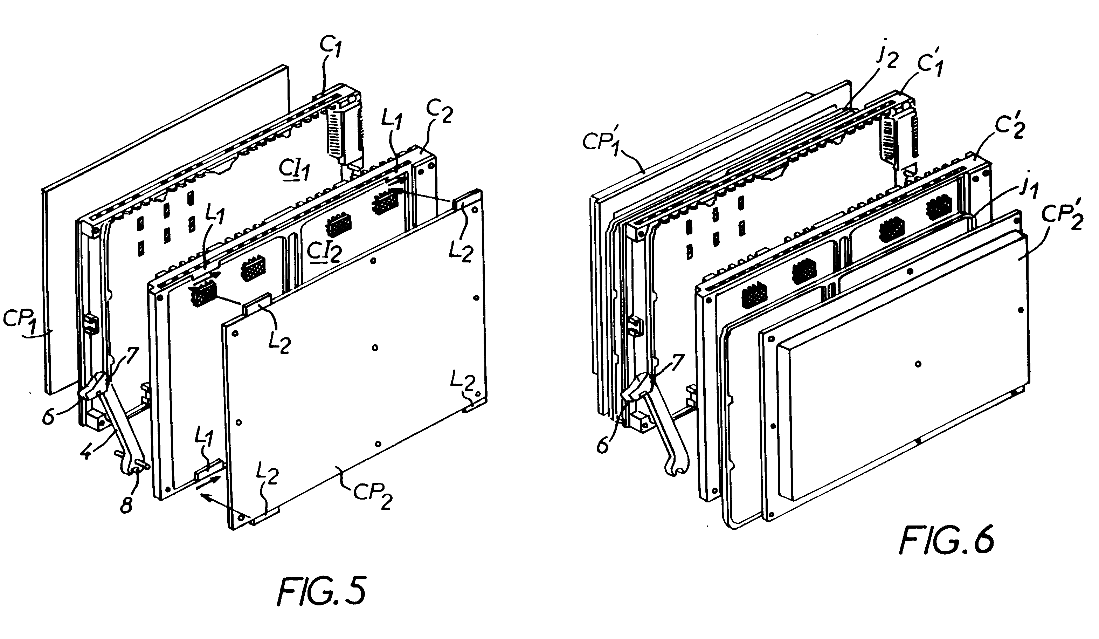

Lors de l'engagement de la structure M1 dans la baie 1, la pièce de verrouillage 6 est à l'état déverrouillé et le levier 4 se trouve légèrement basculé vers l'arrière dans la position indiquée sur les figures 5 et 6.

En fin de course d'engagement, la fourche 8 du levier 4 vient embrasser la barre transversale de l'étrier 9 tandis que les connecteurs des groupes E₁, E₂, E₃ de la structure modulaire M₁ s'engagent dans les connecteurs de la baie 1.

Le verrouillage M₁ de la structure s'obtient ensuite en rabattant le levier 4 contre la face postérieure, jusqu'à ce que le pêne 7 de la pièce de verrouillage 6 vienne en prise sur la gâche G en assurant un blocage en position du levier 4.

Au cours du basculement du levier 4, la fourche 8 exerce une traction sur l'étrier 9 contre l'action du ressort, de sorte qu'en position verrouillée, la structure M1 est soumise à une force orientée en direction du fond de la baie 1, ce qui garantit ainsi la qualité des contacts.

Conformément à l'invention, chaque structure modulaire M₁ à M₆ comprend au moins un cadre C de forme sensiblement rectangulaire de préférence en matière moulée, par exemple en matière composite ou en un métal léger tel que de l'aluminium.

Le bord intérieur de ce cadre C est au moins partiellement mouluré de manière à obtenir des feuillures F₁, F₂ sur lesquelles vient se fixer une carte de circuit imprimé CI entièrement logée dans le volume intérieur délimité par le cadre C.

Dans cet exemple, le cadre C comprend une traverse 11 qui s'étend dans sa partie médiane, parallèlement à ses montants antérieur et postérieur 12, 13, cette traverse 11 étant destinée à assurer le maintien et le raidissement de la carte de circuit imprimé CI.

Le montant postérieur 13 du cadre C présente une feuillure extérieure FE en forme de L munie en sa partie médiane d'une conformation formant une demi-gâche G' et comportant, à ses extrémités, deux perçages transversaux 15, 16 pratiqués dans l'aile de la feuillure FE qui prolonge longitudinalement le cadre C et dont l'un est destiné à recevoir l'axe de pivotement du levier 4 et l'autre, l'axe de pivotement d'un deuxième levier provisionnel.

Le montant antérieur 12 comprend, ici, trois échancrures identiques 17, 18, 19 de forme sensiblement parallélépipédique, qui s'ouvrent au niveau de son bord extérieur 20.

Ces trois échancrures 17, 18, 19 sont destinées à recevoir les trois groupes de connexion E₁, E₂, E₃ qui présentent une forme correspondante et qui comprennent chacun une pluralité d'éléments de connexion axés parallèlement à l'axe longitudinal du cadre C et solidarisés les uns aux autres par leur partie centrale grâce à un enrobage 21 en une matière plastique électriquement isolante.

La conformation générale du cadre C est conçue de telle manière que deux cadres identiques puissent s'assembler l'un à l'autre de telle manière que les échancrures 17, 18, 19 des montants antérieurs 12 soient en coïncidence, que les feuillures en L des montants postérieurs délimitent une rainure dans laquelle vient partiellement se loger le levier 4 et que les perçages 15, 16 soient deux à deux coaxiaux de manière à pouvoir recevoir l'axe dudit levier 4. La fixation des deux cadres, une fois assemblés, peut s'effectuer par vissage. Toutefois, dans le cas où les cadres sont munis de glissières permettant leur assemblage par coulissement total ou partiel, cette fixation par vissage peut être évitée.

Par ailleurs, chacun des cadres C est muni de perçages 22 permettant la fixation par vissage de capots, pouvant consister en des plaques planes CP₁, CP₂ dont le contour épouse sensiblement celui des flancs latéraux du cadre C sur lequel il vient se fixer.

Bien entendu, l'invention ne se limite pas à ce mode de fixation.

Ainsi, le cadre pourrait comprendre deux glissières longitudinales dans lesquelles peut s'engager par coulissement ledit capot. Dans ce cas, le verrouillage peut être obtenu par vissage en un seul point.

De même, les bordures longitudinales du cadre pourraient comprendre des languettes L₁ destinées à venir coopérer avec des languettes correspondantes L₂ prévues sur les bordures longitudinales du capot CP₂, le verrouillage du capot CP₂ étant alors obtenu au terme d'un coulissement relatif partiel permettant d'engager les languettes L₂ du capot CP₂ sous les languettes L₁ du cadre C₂.

Ces capots CP'₁, CP'₂ peuvent éventuellement présenter une forme bombée de manière à augmenter le volume intérieur de la structure modulaire et à permettre ainsi l'emploi de composants électroniques plus volumineux ou l'ajout d'un circuit imprimé supplémentaire directement lié au premier (mécaniquement et/ou électriquement).

Dans les exemples représentés sur les figures 5 et 6, les faces extérieures des montants supérieur et inférieur présentent chacune une gorge longitudinale, tandis que les bords intérieurs de ces montants sont munis d'encoches hémicylindriques qui, une fois l'assemblage de deux cadres réalisés, délimitent des orifices traversants O destinés à assurer la ventilation du volume intérieur de la structure modulaire.

Avantageusement, les capots CP₁, CP₂ - CP'₁, CP'₂ peuvent être réalisés en un matériau thermiquement bon conducteur de manière à pouvoir servir de dissipateurs thermiques.

Dans ce cas, il est possible de faire en sorte que les composants sujets à de fortes dissipations thermiques soient en contact thermique avec les capots CP₁, CP₂ - CP'₁, CP'₂, soit directement, soit par l'intermédiaire d'éléments servant de ponts de conduction thermique.

Ces dispositions permettent donc de résoudre, d'une façon particulièrement efficace, les problèmes de dissipation thermique à la fois par conduction sur des éléments présentant des surfaces de dissipation thermique importantes et par ventilation interne de l'ensemble de la structure et des circuits électroniques qu'elle renferme.

Les ensembles de connexion E₁, E₂, E₃ qui s'engagent dans les échancrures 17, 18, 19 présentent une forme générale sensiblement rectangulaire parallélépipédique, peuvent être réalisés en deux blocs B₁, B₂ - B'₁, B'₂ s'assemblant l'un à l'autre au niveau d'un plan de jonction parallèle au plan de la carte de circuit imprimé CI.

Dans l'exemple de la figure 2, chaque bloc est associé à une face correspondante de la carte de circuit imprimé et comprend deux rangées de connecteurs dont les extrémités internes sont prolongées par des languettes élastiques 26 venant porter par leurs extrémités sur des plages conductrices 27 prévues sur le circuit imprimé.

Avantageusement, le maintien des blocs de connexion B₁, B₂ - B'₁, B'₂ à l'intérieur des échancrures 17, 18, 19 est assuré grâce à des conformations de forme complémentaire desdites échancrures et desdits blocs qui assurent un blocage axial de ces derniers, et aux capots CP₁, CP₂ - CP'₁, CP'₂ (ou à des pièces faisant office de capot) qui viennent en recouvrement sur les échancrures 17, 18, 19.

Un tel montage évite d'avoir à utiliser des structures complètes de connecteur telles qu'elles se trouvent disponibles dans le commerce et qui équipaient jusqu'ici les tiroirs des baies.

De par sa conception, la structure modulaire précédemment décrite est à composition variable.

Elle peut comprendre deux cadres C₁, C₂ assemblés l'un à l'autre et portant chacun une carte de circuit imprimé CI₁, CI₂ et deux capots plats CP₁, CP₂, comme représenté figure 5.

Avantageusement, les circuits imprimés CI₁, CI₂ portés par ces deux cadres C₁, C₂, pourront être directement interconnectés (par exemple à l'aide de connecteurs enfichables), de manière à réduire le nombre de connexions entre chacune des cartes CI₁, CI₂ et les connecteurs fond de panier de la baie 1.

Cette structure pourrait comprendre deux cadres C'₁, C'₂ similaires à ceux des figures 1 à 5 mais munis de capots bombés CP'₁, CP'₂ reliés aux cadres C'₁, C'₂ par l'intermédiaire d'un joint périphérique j₁, j₂ servant d'espaceur (dont l'épaisseur peut être déterminée en fonction des besoins).

Un autre avantage des structures précédemment décrites consiste en ce que l'une des cartes de circuit imprimé peut comprendre des évidements permettant le passage de composants portés par l'autre carte de circuits imprimés.

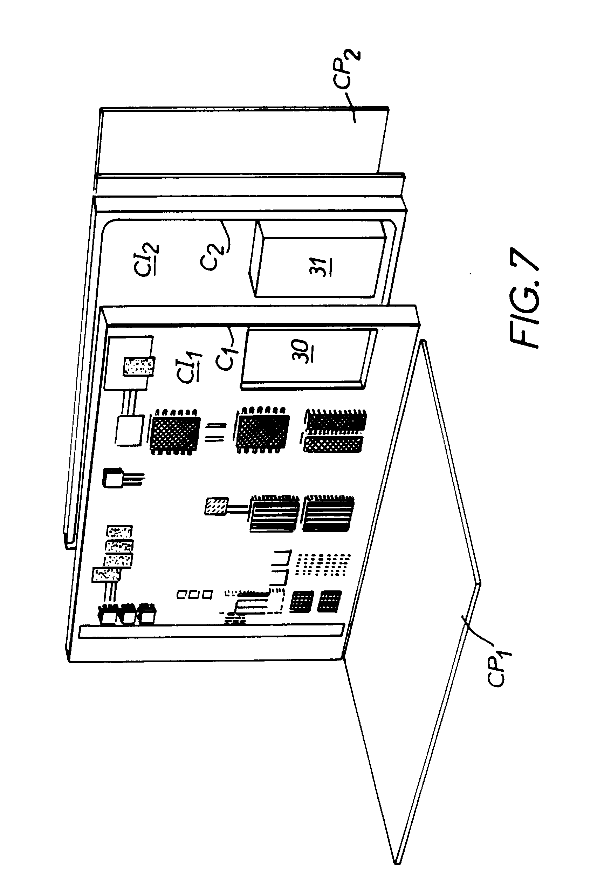

Cette caractéristique se trouve illustrée sur la figure 7 dans laquelle le circuit imprimé CI₁ comprend un évidement rectangulaire 30 au travers duquel passe le boîtier 31 d'un composant électronique volumineux porté par l'autre circuit imprimé CI₂.

Bien entendu, le nombre maximum de cadres utilisés dans une même structure n'est pas limité à deux : Ce nombre est variable en fonction des besoins et de la conception de la baie 1.

## Revendications

1. Structure modulaire porte-carte de circuit imprimé, apte à venir s'engager, à la façon d'un tiroir, dans une baie d'une installation électronique et à se connecter, grâce à des moyens de connexion intégrés, sur des éléments d'interconnexion prévus dans le fond de la baie, cette structure comprenant au moins un cadre (C) réalisé de préférence en une matière moulée, qui délimite au moins un volume plat de forme parallélépipédique et dont le bord intérieur, au moins en partie mouluré, présente des moyens de fixation (F₁, F₂) sur lesquels peut être fixée une carte de circuit imprimé (CI) contenue dans ledit volume,
caractérisée en ce que ledit cadre (C) comporte un montant antérieur (12) conformé de manière à présenter au moins une échancrure (17, 18, 19) dans laquelle est engagé et fixé un groupe de connexion amovible (E₁, E₂, E₃) comprenant une pluralité d'éléments de connexion dont les parties internes (25) sont directement reliées, par l'intermédiaire de liaisons conductrices (26), à des plages conductrices (27) du circuit imprimé (CI), ce cadre (C) comprenant, par ailleurs, deux flancs latéraux munis de moyens de fixation, sur chacun desquels peuvent venir se fixer soit une plaque de fermeture (CP₁, CP₂), de préférence en un matériau thermiquement bon conducteur, soit un deuxième cadre (C) identique au premier de manière à ce que les échancrures des montants antérieurs respectifs des deux cadres soient en coïncidence.

2. Structure selon la revendication 1,
caractérisée en ce que le susdit montant antérieur (12) du cadre (C) comprend sur sa face extérieure, des moyens de détrompage aptes à coopérer avec des moyens correspondants prévus dans le fond de la baie (1), pour interdire toute possibilité d'erreur de connexion.

3. Structure selon la revendication 1,
caractérisée en ce que le montant postérieur (13) du cadre est conformé de manière à recevoir au moins un mécanisme de verrouillage permettant de verrouiller la structure en position engagée et connectée à la baie (1).

4. Structure selon la revendication 3,
caractérisée en ce que le mécanisme de verrouillage fait intervenir un levier basculant (4) monté pivotant autour d'un axe (5) situé à proximité de la face inférieure du cadre (C) et dont la partie supérieure porte une pièce de verrouillage oscillante (6) dont une partie faisant office de pêne vient s'engager dans une conformation en forme de gâche (G) prévue sur la face postérieure (3) dudit cadre, l'extrémité inférieure du levier (4) en forme de fourche (8) étant destinée à venir s'engager dans un étrier (9) monté coulissant sur la face inférieure de la baie (1) et rappelé par un ressort vers l'intérieur de la baie.

5. Structure selon l'une des revendications précédentes,
caractérisée en ce que le susdit cadre (C) comprend une traverse (11) qui s'étend dans sa partie médiane, parallèlement à ses montants antérieur et postérieur (12, 13), cette traverse (11) étant destinée à assurer le maintien et le raidissement de la carte de circuit imprimé (CI).

6. Structure selon la revendication 4,
caractérisée en ce que le montant postérieur (13) du cadre (C) présente une feuillure extérieure, en forme de L muni en sa partie médiane d'une conformation formant une demi gâche de manière à ce que lors de l'assemblage de deux cadres identiques, lesdites feuillures délimitent une rainure dans laquelle peut venir partiellement se loger le levier (4).

7. Structure selon l'une des revendications précédentes,
caractérisée en ce que les montants supérieur et inférieur des cadres (C₁, C₂) comprennent des orifices servant à la ventilation du volume intérieur de la structure modulaire.

8. Structure selon l'une des revendications précédentes,
caractérisée en ce que la susdite plaque de fermeture (CP₁, CP₂) est plane ou éventuellement bombée.

9. Structure selon l'une des revendications précédentes,
caractérisée en ce que la susdite plaque de fermeture est thermiquement reliée à des composants de la carte de circuit imprimé, soit directement, soit par l'intermédiaire d'éléments servant de ponts de conduction thermique.

10. Structure selon l'une des revendications précédentes,
caractérisée en ce que les ensembles de connexion (E₁, E₂, E₃) qui s'engagent dans les échancrures (17, 18, 19) présentent une forme sensiblement parallélépipédique et sont réalisés en deux blocs (B₁, B₂ - B'₁, B'₂) qui s'assemblent l'un à l'autre, au niveau d'un plan de jonction parallèle au plan de la carte de circuit imprimé (CI).

11. Structure selon la revendication 10,
caractérisée en ce que chaque bloc présente au moins une rangée de connecteurs dont les extrémités internes sont prolongées par des languettes élastiques (26) venant porter, par leurs extrémités, sur des plages conductrices (27) prévues sur le circuit imprimé.

12. Structure selon l'une des revendications précédentes,
caractérisée en ce qu'elle comprend deux cadres (C₁, C₂) assemblés l'un à l'autre et portant chacun une carte de circuit imprimé (CI₁, CI₂), et en ce que les deux circuits imprimés sont interconnectés.

13. Structure selon l'une des revendications précédentes,
caractérisée en ce qu'elle comprend un joint périphérique (j₁, j₂) servant d'espaceur, situé entre au moins l'une des plaques de fermeture et le cadre (C₁, C₂).

14. Structure selon l'une des revendications précédentes,
caractérisée en ce qu'elle comprend au moins deux cadres (C₁, C₂) et deux cartes de circuit imprimé (CI₁, CI₂), et en ce que l'une des deux cartes de circuit imprimé (CI₁) comprend un évidement rectangulaire (30) au travers duquel passe un composant électronique (31) porté par l'autre carte de circuit imprimé (CI₂).

15. Structure selon l'une des revendications précédentes,
caractérisée en ce que les cadres (C₁, C₂) sont munis de glissières permettant leur assemblage par coulissement total ou partiel.

16. Structure selon l'une des revendications précédentes,
caractérisée en ce que les cadres (C₁, C₂) sont munis de glissières dans lesquelles peuvent venir s'engager, par coulissement total ou partiel, les plaques de fermeture (CP₁, CP₂).

17. Structure selon l'une des revendications précédentes,
caractérisée en ce que les bordures longitudinales du cadre comprennent des languettes (L₁) destinées à venir coopérer avec des languettes correspondantes (L₂) prévues sur les plaques de fermeture (CP₂) pour assurer un verrouillage rouillage par coulissement partiel desdites plaques sur lesdits cadres (C₂).

## Patentansprüche

1. Modulare Struktur zur Halterung einer Druckschaltungskarte, die nach Art eines Einschubs in einen Einschubschrank einer elektronischen Anlage eingeschoben und mittels integrierter Verbindungsmittel mit Zwischenverbindungselementen verbunden werden kann, die am Boden des Einschubschranks vorgesehen sind, wobei diese Struktur mindestens einen Rahmen (C) aufweist, vorzugsweise aus einem Gußmaterial, der mindestens einen flachen Raum parallelepipedischer Form begrenzt und dessen innerer Rand, der zumindest zum Teil leistenförmig ist, Befestigungsmittel (F₁, F₂) aufweist, an denen eine Druckschaltungskarte (CI) befestigt werden kann, die im Raum enthalten ist,
dadurch gekennzeichnet, daß der Rahmen (C) eine vordere Strebe (12) aufweist, die so ausgebildet ist, daß sie mindestens eine Aussparung (17, 18, 19) besitzt, in die ein lösbarer Verbindungssatz (E₁, E₂, E₃) eingeführt und dort befestigt ist, der eine Vielzahl von Verbindungselementen aufweist, deren innere Teile (25) direkt über leitende Verbindungen (26) mit leitenden Bereichen (27) der Druckschaltung (CI) verbunden sind, wobei dieser Rahmen (C) außerdem zwei mit Befestigungsmitteln versehene seitliche Flanken aufweist, an denen je entweder eine Verschlußplatte (CP₁, CP₂), vorzugsweise aus gut wärmeleitendem Material, oder ein zweiter Rahmen (C) gleich dem ersten so befestigt werden kann, daß die Aussparungen der vorderen Streben der beiden Rahmen zusammenfallen.

2. Struktur nach Anspruch 1, dadurch gekennzeichnet, daß die vordere Strebe (12) des Rahmens (C) auf ihrer Außenseite Unverwechselbarkeitsmittel aufweist, die mit an der Rückwand des Einschubschranks (1) vorgesehenen entsprechenden Mitteln zusammenwirken können, um jede Möglichkeit einer falschen Verbindung auszuschließen.

3. Struktur nach Anspruch 1, dadurch gekennzeichnet, daß die hintere Strebe (13) des Rahmens so ausgebildet ist, daß sie mindestens einen Verriegelungsmechanismus aufnehmen kann, der es ermöglicht, die Struktur in der eingeschobenen und mit dem Einschubschrank (1) verbundenen Stellung zu verriegeln.

4. Struktur nach Anspruch 3, dadurch gekennzeichnet, daß der Verriegelungsmechanismus einen Kipphebel (4) verwendet, der um eine Achse (5) schwenkbar angeordnet ist, die sich in der Nähe der unteren Seite des Rahmens (C) befindet, und dessen oberer Teil ein schwingendes Verriegelungsstück (6) trägt, von dem ein Teil, der als Riegel dient, sich in eine Ausbildung in Form einer Schloßplatte (G) auf der Rückseite (3) des Rahmens einfügt, wobei das untere Ende des Hebels (4) in Form einer Gabel (8) dazu bestimmt ist, sich in einen Bügel (9) einzufügen, der gleitend auf der Unterseite des Einschubschranks (1) montiert ist und von einer Feder ins Innere des Einschubschranks gezogen wird.

5. Struktur nach einem der vorhergehenden Ansprüche, dadurch gekennzeichnet, daß der Rahmen (C) eine Querstrebe (11) aufweist, die sich in seinem mittleren Bereich parallel zu seinen vorderen und hinteren Streben (12, 13) erstreckt, wobei diese Querstrebe (11) den Halt und die Versteifung der Druckschaltungskarte (CI) gewährleisten soll.

6. Struktur nach Anspruch 4, dadurch gekennzeichnet, daß die hintere Strebe (13) des Rahmens (C) einen äußeren L-förmigen Falz aufweist, der in seinem mittleren Bereich eine Ausbildung in Form einer halben Schloßplatte aufweist, damit beim Zusammenbau von zwei gleichen Rahmen diese Falze eine Rille begrenzen, in die der Hebel (4) sich teilweise einfügen kann.

7. Struktur nach einem der vorhergehenden Ansprüche, dadurch gekennzeichnet, daß die obere und die untere Strebe der Rahmen (C₁, C₂) Öffnungen aufweisen, die zur Entlüftung des Innenraums der modularen Struktur dienen.

8. Struktur nach einem der vorhergehenden Ansprüche, dadurch gekennzeichnet, daß die Verschlußplatte (CP₁, CP₂) eben oder ggf. gewölbt ist.

9. Struktur nach einem der vorhergehenden Ansprüche, dadurch gekennzeichnet, daß die Verschlußplatte thermisch mit Bauteilen der Druckschaltungskarte entweder direkt oder über Elemente verbunden ist, die als Wärmeleitungsbrücken dienen.

10. Struktur nach einem der vorhergehenden Ansprüche, dadurch gekennzeichnet, daß die Verbindungseinheiten (E₁, E₂, E₃), die sich in die Aussparungen (17, 18, 19) einfügen, eine im wesentlichen parallelepipedische Form aufweisen und aus zwei Blöcken (B₁, B₂ - B'₁, B'₂) bestehen, die zusammengebaut werden in Höhe einer Verbindungsebene parallel zur Ebene der Druckschaltungskarte (CI).

11. Struktur nach Anspruch 10, dadurch gekennzeichnet, daß jeder Block mindestens eine Reihe von Verbindern aufweist, deren innere Enden durch elastische Zungen (26) verlängert werden, die mit ihren Enden auf leitenden Bereichen (27) aufliegen, die auf der Druckschaltung vorgesehen sind.

12. Struktur nach einem der vorhergehenden Ansprüche, dadurch gekennzeichnet, daß sie zwei Rahmen (C₁, C₂) aufweist, die zusammengesetzt sind und je eine Druckschaltungskarte (CI₁, CI₂) tragen, und daß die beiden Druckschaltungen miteinander verbunden sind.

13. Struktur nach einem der vorhergehenden Ansprüche, dadurch gekennzeichnet, daß sie eine periphere Dichtung (j₁, j₂) aufweist, die als Abstandshalter dient und die sich zwischen mindestens einer der Verschlußplatten und dem Rahmen (C₁, C₂) befindet.

14. Struktur nach einem der vorhergehenden Ansprüche, dadurch gekennzeichnet, daß sie mindestens zwei Rahmen (C₁, C₂) und zwei Druckschaltungskarten (CI₁, CI₂) aufweist und daß eine der beiden Druckschaltungskarten (CI₁) einen rechteckigen Ausschnitt (30) aufweist, durch den ein elektronisches Bauteil (31) dringt, das von der anderen Druckschaltungskarte (CI₂) getragen wird.

15. Struktur nach einem der vorhergehenden Ansprüche, dadurch gekennzeichnet, daß die Rahmen (C₁, C₂) mit Gleitschienen versehen sind, die ihren Zusammenbau durch vollständiges oder teilweises Gleiten ermöglichen.

16. Struktur nach einem der vorhergehenden Ansprüche, dadurch gekennzeichnet, daß die Rahmen (C₁, C₂) mit Gleitschienen versehen sind, in die die Verschlußplatten (CP₁, CP₂) sich durch vollständiges oder teilweises Gleiten einfügen können.

17. Struktur nach einem der vorhergehenden Ansprüche, dadurch gekennzeichnet, daß die Längskanten des Rahmens Laschen (L₁) aufweisen, die mit entsprechenden Laschen (L₂) auf den Verschlußplatten (CP₂) zusammenwirken sollen, um eine Verriegelung durch teilweises Gleiten der Platten auf den Rahmen (C₂) zu gewährleisten.

## Claims

1. A modular printed circuit board holder structure, capable of engaging, in drawer-like fashion, in a rack of an electronic installation, and of connecting by means of integrated connecting means to interconnection elements provided at the back of the rack, said structure comprising at least one frame (C), preferably manufactured in molded material, delimiting at least one parallelepiped-shaped flat volume whose inner contour edge, which is at least partially crimped, has attachment means (F₁, F₂) to which can be attached a printed circuit board (CI) contained in said volume,
characterized in that said frame (C) comprises a front vertical member (12) shaped so as to have a least one indentation (17, 18, 19) in which is engaged and attached at least one removable connection group (E₁, E₂, E₃) comprising a plurality of connection elements whose inner parts (25) are directly connected, by means of conductive links (26), to conductive areas (27) of the printed circuit (CI), said frame (C) further comprising two lateral flanks equipped with attachment means to each of which can be attached either a covering plate (CP₁, CP₂), preferably in a good heat conducting material, or a second frame (C) identical to the first one so that the indentations of the respective front vertical members of the two frames coincide.

2. The structure as claimed in claim 1,
characterized in that said front vertical member (12) of said frame (C) can comprise, on its outer side, polarizing means capable of cooperating with corresponding means provided in the back of said rack (1), to prevent all possibility of connection error.

3. The structure as claimed in claim 1,
characterized in that the rear vertical member (13) of said frame is shaped so as to receive at least one locking mechanism enabling said structure to be locked in its engaged position connected to said rack (1).

4. The structure as claimed in claim 3,
characterized in that said locking mechanism uses a tilting lever (4) mounted pivotably about an axis (5) situated close to the lower side of said frame (C) and whose upper part bears an oscillating locking part (6) of which a part acting as sliding bolt engages into a conformation in the shape of a strike plate (G) provided on the rear side (3) of said frame, the lower end of said fork(8)-shaped lever (4) being intended to engage in a clamp (9) mounted slidably on the lower side of said rack (1) and pulled back by a spring towards the inside of said rack.

5. The structure as claimed in one of the preceding claims,
characterized in that said frame (C) comprises a crosspiece (11) extending, in its medial part, parallel to its front and rear vertical members (12, 13), said crosspiece (11) being intended to ensure the holding up and stiffening of the printed circuit board (CI).

6. The structure as claimed in claim 4,
characterized in that said rear vertical member (13) of said frame (C) has an L-shaped outer rabbet with, in its medial part, a conformation forming a half strike plate such that, when two identical frames are assembled, said rabbets delimit a groove in which said lever (4) can be partially housed.

7. The structure as claimed in one of the preceding claims,
characterized in that the upper and lower vertical members of said frames (C₁, C₂) comprise orifices serving to ventilate the interior volume of said modular structure.

8. The structure as claimed in one of the preceding claims,
characterized in that said covering plate (CP₁, CP₂) is flat or possibly bulged.

9. The structure as claimed in one of the preceding claims,
characterized in that said covering plate is thermally connected to components of the printed circuit board, either directly or through the intermediary of elements serving as thermal conduction bridges.

10. The structure as claimed in one of the preceding claims,
characterized in that said connection groups (E₁, E₂, E₃) engaging in said indentations (17, 18, 19) are substantially parallelepiped-shaped, and are manufactured in two blocks (B₁, B₂ - B'₁, B'₂) with one another at the level of a junction plane parallel to the plane of said printed circuit board (CI).

11. The structure as claimed in claim 10,
characterized in that each connection group has at least one row of connectors whose internal ends are prolonged by elastic tongues (26) that come to rest by their ends against conductive areas (27) provided on said printed circuit.

12. The structure as claimed in one of the preceding claims,
characterized in that it comprises two frames (C₁, C₂) assembled together and each bearing a printed circuit board (CI₁, CI₂), and in that said two printed circuit boards are interconnected.

13. The structure as claimed in one of the preceding claims,
characterized in that it comprises a peripheral seal (j₁, j₂) acting as a spacer and situated between at least one of said covering plates and said frame (C₁, C₂).

14. The structure as claimed in one of the preceding claims,
characterized in that it comprises at least two frames (C₁, C₂) and two printed circuit boards (CI₁, CI₂), and in that one of said two printed circuit boards (CI₁) comprises a rectangular recess (30) through which an electronic component (31) borne by the other printed circuit (CI₂) passes.

15. The structure as claimed in one of the preceding claims,
characterized in that said frames (C₁, C₂) are fitted with sliding rails enabling them to be assembled together by complete or partial sliding.

16. The structure as claimed in one of the preceding claims,
characterized in that said frames (C₁, C₂) are fitted with sliding rails in which said covering plates (CP₁, CP₂) can engage by complete or partial sliding.

17. The structure as claimed in one of the preceding claims,
characterized in that the longitudinal edges of said frame comprise tongues (L₁) intended to cooperate with corresponding tongues (L₂) provided on said covering plates (CP₂) to ensure locking by partial sliding of said plates on said frames (C₂).
